Europäisches Patentamt

European Patent Office

Office européen des brevets

(11) Veröffentlichungsnummer: **0 293 757 B1**

# (12) EUROPÄISCHE PATENTSCHRIFT

(45) Veröffentlichungstag der Patentschrift: **21.10.92**

(51) Int. Cl.5: **C30B 15/20**

(21) Anmeldenummer: **88108397.6**

(22) Anmeldetag: **26.05.88**

(54) **Verfahren und Vorrichtung zur Ermittlung einer Bestimmungsgrösse für den Übergangsbereich zwischen Schmelze und Kristall.**

(30) Priorität: **30.05.87 DE 3718260**

(43) Veröffentlichungstag der Anmeldung:
**07.12.88 Patentblatt 88/49**

(45) Bekanntmachung des Hinweises auf die Patenterteilung:
**21.10.92 Patentblatt 92/43**

(84) Benannte Vertragsstaaten:
**AT BE CH DE FR GB IT LI LU NL SE**

(56) Entgegenhaltungen:
**DE-A- 3 640 868**
**DE-C- 3 432 467**
**GB-A- 1 457 275**
**US-A- 4 176 002**

**PATENT ABSTRACTS OF JAPAN, Band 7, Nr. 201 (C-184)[1346], 6. September 1983; & JP-A-58 099 196 (HITACHI SEISAKUSHO K.K.) 13-06-1983**

**SOVIET INVENTIONS ILLUSTRATED, Woche 8347, 12. Januar 1983, Sektion J, Derwent Publications Ltd, London, GB; & SU-A-899 740 (EREV UNIV RADIATION) 25-01-1982**

(73) Patentinhaber: **Forschungszentrum Jülich GmbH**
**Postfach 1913**
**W-5170 Jülich(DE)**

(72) Erfinder: **Boden, Karl**
**Siemensstrasse 20**
**W-5170 Jülich(DE)**
Erfinder: **Janssen, Franz**
**Hartweg 22**
**W-5137 Waldfeucht-Bocket(DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung bezieht sich auf ein Verfahren zur Ermittlung einer Bestimmungsgröße für den Übergansbereich zwischen Schmelze und Kristall bei einer Vorrichtung zum tiegellosen Zonenschmelzen oder zum Ziehen des Kristalls aus einem Tiegel, die einen elektrischen Antrieb zur Rotation des Kristalls und/oder des Tiegels aufweist.

Der Kristall wächst an der Phasengrenze zwischen Schmelze und Kristall. Für das Wachstum des Kristalls ist daher die Beschaffenheit des Übergangsbereichs zwischen Schmelze und Kristall von erheblicher Bedeutung. Beim Tiegelziehverfahren nach Czochralski befindet sich die Phasengrenze oberhalb der Ebene der Schmelzoberfläche. Es bildet sich zwischen Schmelze und Kristall aufgrund der Oberflächenspannung eine Schmelzenbrücke mit membranähnlicher Oberflächenform, der sog. Meniskus, aus. Die physikalischen Zustandsgrößen der Schmelzenbrücke, so beispielsweise deren Temperatur, Dichte, aber auch deren Form haben Auswirkungen auf den Kristallzuchtprozeß und damit auf die Qualität und Form des entstehenden Kristalls, beispielsweise auch auf dessen Durchmesser. So ist mit sinkender Meniskushöhe eine Tendenz zur Vergrößerung des Durchmessers des Kristalls und umgekehrt mit wachsender Meniskushöhe eine Tendenz zur Verkleinerung des Durchmessers des Kristalls zu beobachten.

Die Beschaffenheit der Schmelzenbrücke ist außerdem von äußeren Einflußgrößen, wie Drehgeschwindigkeit und Drehrichtung des Tiegels bzw. des Kristalls zueinander sowie davon abhängig, inwieweit es gelingt, die axiale Verschiebung des Kristalls relativ zur Schmelze genau an die Wachstumsgeschwindigkeit des Kristalls anzupassen. Dies gelang bisher jedoch nur unbefriedigend, nicht zuletzt wegen der Vielfalt der die Beschaffenheit der den Übergangsbereich zwischen Schmelze und Kristall bestimmenden Parameter und der fehlenden Möglichkeiten zu deren Ermittlung. So ist aus der DE-PS 34 32 467 ein Verfahren bekannt, eine automatische Regelung des Kristalldurchmessers dadurch durchzuführen, daß die Gewichtsänderung des wachsenden Kristalls bzw. die der Schmelze als Regelgröße benutzt wird. Dabei wird die Istgewichtsänderung ermittelt, diese mit einer Sollgewichtsänderung verglichen und die Differenz zum automatischen Verstellen der Heizleistung bzw. der Geschwindigkeit der axialen Verschiebung herangezogen. Diese bekannte Verfahrensweise basiert zwar auf einer sehr genauen und störungsfreien Gewichtsmessung, sie führt dennoch nicht für den Kristallzuchtprozeß zu voll befriedigenden Ergebnissen, da sie die den Übergansbereich für das Kristallwachstum bestimmenden Einflußgrößen nicht hinreichend berücksichtigt. So kommt beispielsweise bei dem Tiegelziehverfahren nach Czochralski eine Verfälschung des Gewichtsmeßergebnisses, das als Regelgröße dient, dadurch zustande, daß die Schmelzenbrücke mit ihrem Gewicht am wachsenden Kristall hängt und dieses Zusatzgewicht von der Gewichtsmeßeinrichtung mitgemessen wird. Da aber die Höhe der Schmelzenbrücke bzw. die Höhe des Meniskus, bedingt durch nicht vollständig beherrschbare Einflußgrößen, zeitlich schwankt, ist die Gewichtsmessung fehlerhaft und damit die Regelung des Kristalldurchmessers nach der bekannten Verfahrensweise zu ungenau.

Es ist daher Aufgabe der Erfindung, ein Verfahren zu schaffen, das zu einer Bestimmungsgröße führt, die eine Aussage über die Beschaffenheit des Übergansbereiches zwischen Schmelze und Kristall zuläßt und die nach Möglichkeit in einem funktionellen Zusammenhang mit anderen, für den Kristallzuchtprozeß bestimmenden Größen steht.

Die der Erfindung zugrundeliegende Aufgabe wird durch Ermittlung des Reibungsmomentes für den Übergangsbereich zwischen Schmelze und Kristall gelöst, wobei eine Vorrichtung mit einer Stab- und/oder Tiegelhalterung verwendet wird, die einen Magneten (Axialstabilisierungsmagnet) zur Aufhängung der einen magnetisierbaren Kern aufweisenden Halterung mit einer Einrichtung zur axialen Verschiebung und einer Radialstabilisierungseinrichtung für den magnetisierbaren Kern aufweist, die aus den magnetisierbaren Kern berührungslos umschließenden Elektromagneten, einem elektronischen Regelgerät und Positionssensoren besteht, wobei die Elektromagnete vom elektronischen Regelgerät mit Signalen beaufschlagt werden, die von diesem als Funktion der Signale der Positionssensoren, welche auf die Abweichungen des magnetisierbaren Kerns und seiner Sollage ansprechen, erzeugt werden, wobei der elektrische Antrieb über Magnetfelder am magnetisierbaren Kern angreift, und wobei

a) das Reibungsmoment mittels elektrischer Daten des Antriebsmotors unter Berücksichtigung von Kennwerten des Antriebsmotors ermittelt wird oder

b) das über Magnetfelder nach außen übertragene Reibungsmoment mittels Momentmeßzellen gemessen wird oder

c) das Reibungsmoment aus der relativen Drehzahlabnahme der Stab- und/oder Tiegelhalterung je Zeiteinheit nach Abschalten des Antriebsmotors unter Berücksichtigung des aktuellen Trägheitsmoments der rotierenden Teile ermittelt wird.

Die Verwendung der vorgenannten berührungslos gelagerten Stab- und Tiegelhalterung eröffnet die Möglichkeit, durch den Übergansbereich bedingte Reibungsmomente - unabhängig davon, ob eine geschlossene Zuchtkammer vorhanden ist oder nicht - mit höchster Genauigkeit zu messen. Voraussetzung ist, daß als elektrische Antriebe Motore ohne mechanische Kommutatoren und Schleifringe verwendet werden, so daß auch vom rotatorischen Antrieb her die Reibungsfreiheit der Aufhängung der Halterung gewährleistet ist. Dies ist beispielsweise bei Synchronmotoren (z.B. Reluktanzoder Hysteresemotoren) oder Asynchronmotoren (z.B. Kurzschlußläufermaschinen) der Fall.

Da die Meßeinrichtung für das Reibungsmoment außerhalb des Zuchtraumes angeordnet werden kann (die zwischen Kristall und Schmelze auftretenden Reibungsmomente werden über Magnetkräfte nach außen übertragen), unterliegt sie keiner Beeinträchtigung durch Zuchtraumdruck, -temperatur und Korrosion, so daß das Reibungsmoment von keinem Störpegel und keiner Signaldrift überlagert wird. Für den Fall, daß die Reibungsmomente am feststehenden Kristall bzw. Tiegel (dabei drehen Tiegel bzw. Kristall) ermittelt werden sollen, wird das jeweils feststehende Teil zweckmäßigerweise durch eine Magnetkupplung fixiert und die Reibungsmomente an deren Außenelementen ermittelt.

Bei der Durchführung der verfahrensvariante a) werden die aktuellen elektrischen Antriebswerte (beispielsweise Strom oder Spannung oder Leistung) des Antriebsmotors in bekannter Weise gemessen und mit Motormomentkennwerten in Beziehung gesetzt. Die Abweichungen dieser Antriebswerte von den Antriebswerten bei unbelastetem Antrieb ergeben die gewünschten Reibungsmomente.

Zur Messung des Reibungsmomentes nach Verfahrensvariante b) können Kraftmeßzellen verwendet werden, die die Umfangskraft auf einem vorgegebenen Radius messen. Diese Meßzellen, von denen mehrere, z.B. drei, am Umfang verteilt angebracht sein können, können sowohl den gesamten Stator abstützen als auch lediglich den Antriebsstator bzw. die Außenelemente einer Magnetkupplung bie feststehendem Kristall oder Tiegel. Bei dieser Verfahrensvariante wird das Motordrehmoment kontinuierlich gemessen, die Kristalldrehzahl bleibt konstant, da der Antriebsmotor nicht ausgeschaltet werden muß.

Nach Verfahrensvariante c) wird das Reibungsmoment über die relative Drehzahlabnahme nach der bekannten Beziehung

$$\frac{\dot{\omega}}{\omega} = \frac{t_2 - t_1}{t_2 \cdot t_2}$$

bestimmt.

Man mißt die Zeiten $t_1$ und $t_2$ in aufeinanderfolgenden Messungen, die die Halterung für eine gegebene Anzahl von Umdrehungen benötigt, und verwendet dabei z.B. das periodische Unwuchtsignal der radialen Magnetlagersensoren. Die Periodenzeit pro Umdrehung wird dabei z.B. mit einer Quarzuhr in bekannter Weise elektronisch gemessen. Die zur exakten Berechnung des Reibungsmomentes erforderlichen weiteren Größen, wie Massenträgheitsmoment von Halterung (einschließlich Kristall bzw. Tiegel), dessen zeitliche Änderung und die Drehzahl stehen für die Meßwertverarbeitung z.B. in einem Prozessor entweder als empirisch ermittelter Datensatz zur Verfügung oder sie werden aus einer separat durchzuführenden Gewichtsmessung abgeleitet.

Für den Kristallzuchtprozeß ist ein konstantes Drehen von Kristall bzw. Tiegel wünschenswert. Eine Weiterausgestaltung des Verfahrens gemäß der Erfindung besteht daher darin, daß die Verfahrensalternativen a) und b) bei konstanter Drehzahl der Stab- und Tiegelhalterung durchgeführt werden.

Die Erfindung geht von der Erkenntnis aus, daß das Reibungsmoment selbst ohne Störgrößen ermittelt werden kann, dabei aber mit einer Reihe von Einflußgrößen für den Übergangsbereich zwischen Schmelze und Kristall in funktioneller Beziehung steht und daher bei Konstanthaltung bestimmter Größen eine Aussage über andere Einflußgrößen zu machen gestattet. So ist das Reibungsmoment neben Zähigkeit und Dichte (die eine Funktion der Temperatur ist) von Kristalldurchmesser, der Drehzahl und der Drehrichtung des Kristalls bzw. des Tiegels zueinander, von der Meniskushöhe sowie von der form der Phasengrenze abhängig.

Es hat sich gezeigt, daß das Reibungsmoment proportional von $D^4$ (D: aktueller Kristalldurchmesser an der Phasengrenze) abhängt. Damit ist das Reibungsmoment bei sonst konstanten Einflußgrößen ein genaues, und selbst bei Schwankungen der anderen Einflußgrößen noch ein gutes Maß für den aktuellen Kristalldurchmesser bzw. dessen Änderung. Hiervon ausgehend besteht eine Weiterausgestaltung des Verfahrens gemäß der Erfindung darin, daß das ermittelte Reibungsmoment der Ermittlung des Kristalldurchmessers an der Phasengrenzfläche zwischen Schmelze und Kristall dient, wobei das Reibungsmoment ein direktes Maß für den Kristalldurchmesser ist.

Andererseits stehen auch Meniskushöhe und aktueller Kristalldurchmesser in einem funktionellen Zusammenhang. Dabei führt eine Vergrößerung der Meniskushöhe zu einer Verkleinerung des Kristalldurchmessers und umgekehrt eine Verkleinerung der Meniskushöhe zu einer Vergrößerung des Kristalldurchmessers. Wird über eine Reibungsmomentmessung beispielsweise eine Vergrößerung des aktuellen Kristalldurchmesser angezeigt, so bewirkt eine größere axiale Linearverschiebung, d.h. eine Vergrößerung des Abstandes zwischen Kristall und Schmelze, eine Vergrößerung der Meniskushöhe und damit - infolge der entsprechenden Verformung des Meniskus - eine Verkleinerung des aktuellen Kristalldurchmessers.

In weiterer Ausgestaltung der auf die Bestimmung des Kristalldurchmessers gerichteten Verfahrensweise gemäß der Erfindung wird daher das ermittelte Reibungsmoment als direktes Maß für den Kristalldurchmesser an der Phasengrenzfläche zwischen Schmelze und Kristall in einem Regelkreis zur Regelung des Kristalldurchmessers eingesetzt. Im Regelkreis für den Kristalldurchmesser entspricht dabei ein Momentsollwert dem gewünschten Kristalldurchmesser. Abweichungen des Istmoments vom Sollwert werden durch Verstellen der Geschwindigkeit der linearen axialen Verschiebung, aber beispielsweise auch durch Veränderung der Heizleistung ausgeregelt.

Eine weitere Einsatzmöglichkeit des Reibungsmomentes als Bestimmungsgröße für den Übergangsbereich zwischen Schmelze und Kristall besteht in folgendem: Bei relativ kleinem Kristalldurchmesser macht sich die Abhängigkeit des Reibungsmomentes von den anderen Einflußgrößen stärker bemerkbar. Dies ergibt - bei konstanter Temperatur der Schmelze und konstanter Drehzahl und Drehrichtung - die Möglichkeit, den Reibungsmoment-Meßwert als Korrekturgröße bei der eingangs genannten, aus der DE-PS 34 32 467 bekannten Durchmesserregelung einzusetzen, bei der die Gewichtsmessung des wachsenden Kristalls bzw. der Schmelze als Regelgröße benutzt wird. Das Reibungsmoment ist dabei ein Maß für die Meniskushöhe und damit für das Gewicht der Schmelzenbrücke.

Die mittels des Reibungsmomentes korrigierte Kristalldurchmesserregelung kann beispielsweise eingesetzt werden zur Ausformung des Durchmesserverlaufs an der Kristallschulter (der Teil des Kristalls zwischen Hals und Rumpf). Da die Empfindlichkeit sowohl der Reibungsmomentmessung als auch der Gewichtsmessung bei kleinen Kristalldurchmessern gering ist, führt die Kombination beider Methoden zu einer erhöhten Genauigkeit.

Die der Erfindung zugrundeliegende Aufgabe wird ferner durch eine Vorrichtung zum tiegellosen Zonenschmelzen oder zum Ziehen des Kristalls aus einem Tiegel mit einer Stab- und/oder Tiegelhalterung gelöst, die Magneten zur Aufhängung der einen magnetisierbaren Kern aufweisenden Halterung mit einer Einrichtung zur axialen Verschiebung und eine Radialstabilisierungseinrichtung für den magnetisierbaren Kern aufweist, die aus den magnetisierbaren Kern berührungslos umschließenden Elektromagneten, einem elektronischen Regelgerät und Positionssensoren besteht, wobei die Elektromagnete vom elektronischen Regelgerät mit Signalen beaufschlagt werden, die von diesem als Funktion der Signale der Positionssensoren, welche auf die Abweichungen des magnetisierbaren Kerns von seiner Sollage ansprechen, erzeugt werden, und die einen elektrischen Antrieb zur Rotation der Halterung aufweist, der über Magnetfelder reibungsfrei am magnetisierbaren Kern angreift.

Die Vorrichtung ist zur Durchführung der Verfahrensvariante a) mit einer Einrichtung ausgestattet, die ein dem Reibungsmoment entsprechendes Ausgangssignal aus Meßdaten der aktuellen Antriebswerte (Strom oder Spannung oder Leistung) des elektrischen Antriebs unter Berücksichtigung von Kennwerten des Antriebsmotors erzeugt.

Zur Durchführung der Verfahrensvariante b) ist eine Drehmomentmeßeinrichtung mit Momentmeßzellen zur Messung des über Magnetfelder nach außen übertragenen Reibungsmomentes vorgesehen.

Für die dritte Verfahrensvariante c) weist die Vorrichtung eine Einrichtung auf, die ein dem Reibungsmoment entsprechendes Ausgangssignal aus der relativen Drehzahlabnahme der Halterung je Zeiteinheit nach Abschalten des Antriebsmotors unter Berücksichtigung des aktuellen Trägheitsmoments der rotierenden Teile erzeugt.

Für den Fall, daß die Reibungsmomente am feststehenden Kristall oder Tiegel - wobei jeweils alternativ Tiegel oder Kristall drehen - ermittelt werden sollen, besteht eine Weiterausgestaltung der Vorrichtung gemäß der Erfindung darin, daß eine Magnetkupplung zur Fixierung von Tiegel oder Kristall vorgesehen ist, die am magnetisierbaren Kern angreift, und daß die Einrichtung zur Ermittlung des Reibungsmomentes mit Außenelementen der Magnetkupplung in Verbindung steht.

Zur Durchführung der Regelung des Kristalldurchmessers ist in Weiterausgestaltung der Vorrichtung gemäß der Erfindung eine Regeleinrichtung vorgesehen, in die der ermittelte Reibungsmoment/Meßwert als Maß für den Kristalldurchmesser eingespeist wird.

Der Verbesserung der aus der DE-PS 34 32 467 bekannten Durchmesserregelung dient eine weitere Weiterausgestaltung der Vorrichtung gemäß der Erfindung, die in einer Kombination der Regeleinrichtung zur Regelung des Kristalldurchmessers mittels einer geeignet angeordneten Kraftmeßeinrichtung mit einer Einrichtung zur Ermittlung des Reibungsmomentes besteht, wobei der Reibungsmoment/Meßwert als Korrekturgröße eingesetzt wird.

Ausführungsformen der Vorrichtung gemäß der Erfindung sind in der Zeichnung schematisch dargestellt und werden im folgenden näher erläutert:

Es zeigen

Figur 1      Vorrichtung mit magnetischen Aufhängungen zur gegenläufigen Drehung von Kristall und Tiegel mit Einrichtungen zur Regelung des Kristalldurchmessers und zur Durchführung der Verfahrensvariante b) an der Aufhängung des Kristalls;

Figur 1a      Schnitt durch die Vorrichtung gemäß Fig. 1 längs der Linie A/A';

Figur 2      Vorrichtung mit rotierendem Kristall und über eine Magnetkupplung fixiertem Tiegel mit Einrichtung zur Regelung des Kristalldurchmessers und zur Durchführung der Verfahrensvariante b) an der Aufhängung des Tiegels;

Figur 2a      Schnitt durch die Vorrichtung gemäß Fig. 2 längs der Linie A/A';

Figur 2b      Vorrichtung gemäß Fig. 2 mit weiterausgestalteter Meß- und Regeleinrichtung;

Figur 3      Vorrichtung mit rotierendem Kristall mit Einrichtungen zur Regelung des Kristalldurchmessers und Durchführung einer weiteren Verfahrensvariante b) an der Aufhängung des Kristalls;

Figur 4      Vorrichtung mit rotierendem Kristall mit Einrichtungen zur Regelung des Kristalldurchmessers und zur Durchführung der Verfahrensvariante c) an der Aufhängung des Kristalls;

Figur 5      Vorrichtung mit rotierendem Kristall mit Einrichtungen zur Regelung des Kristalldurchmessers und zur Durchführung der Verfahrensvariante a) an der Aufhängung des Kristalls;

Figur 6      Vorrichtung mit rotierendem Kristall mit einer Kombination einer Kristalldurchmesser/Regeleinrichtung mittels einer Kraftmeßeinrichtung mit einer Einrichtung zur Ermittlung des Reibungsmoments.

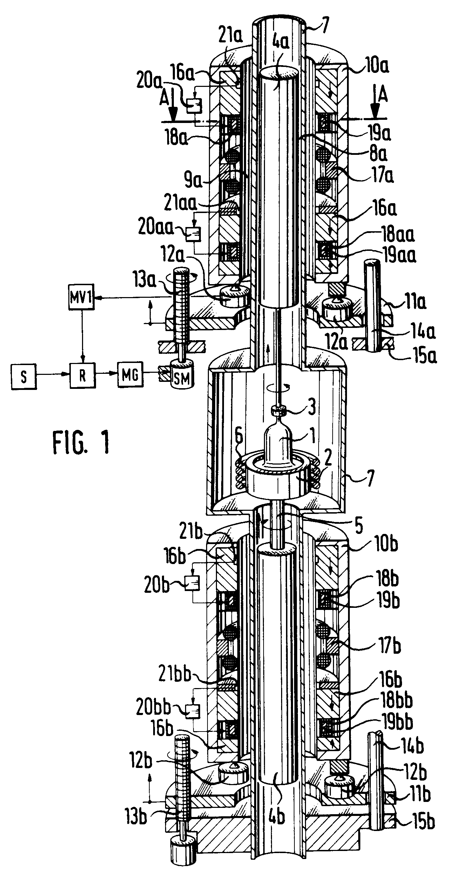

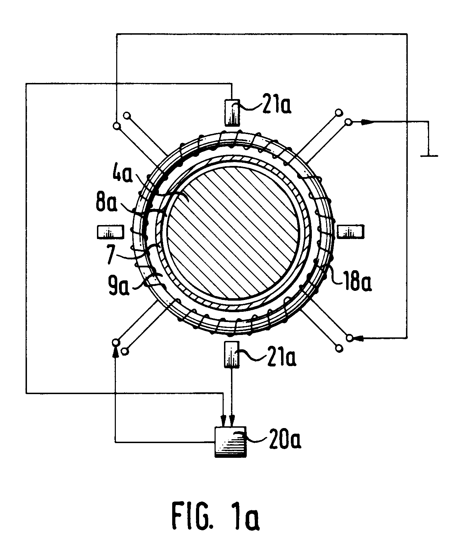

Bei der in Fig. 1 dargestellten Vorrichtung sind sowohl Kristall 1 als auch Tiegel 2 magnetisch aufgehängt. Der Kristall 1 ist dabei über die Befestigung 3 mit dem magnetisierbaren Kern 4a, der Tiegel 2 über den Stab 5 mit dem magnetisierbaren Kern 4b verbunden. Der Tiegel 2 ist von der Wicklung 6 einer Heizspule (Gleichstrom oder Hochfrequenzspule) umgeben.

Kristall, Tiegel, Heizwicklung sowie die magnetisierbaren Kerne der Aufhängung befinden sich innerhalb einer durch die Wandung 7 gebildeten, hermetisch verschließbaren Zuchtkammer, wobei die erstgenannten Elemente von der Wandung durch Ringspalte getrennt sind (so ist beispielsweise der Kern 4a von der Wandung durch den Ringspalt 8a getrennt).

Außerhalb der Zuchtkammer befinden sich die Befestigungsrahmen 10a und 10b für die Elemente der magnetischen Aufhängungen und des rotatorischen Antriebs, die von der Wandung ebenfalls durch Ringspalte (beispielsweise durch Ringspalt 9a) getrennt sind. Die Befestigungsrahmen ruhen auf Platten 11a und 11b, wobei zwischen Platten und Befestigungsrahmen jeweils Momentmeßzellen 12a und 12b angeordnet sind (die Momentmeßzellen 12b sind jedoch zur Ermittlung des Reibungsmoments nicht eingesetzt). Die Platten 11a und 11b sind mittels Spindeln 13a und 13b mit Führungen 14a und 14b in der Höhe veschiebbar, wobei Spindeln und Führungen auf den Festen Unterlagen 15a und 15b (an der auch die Zuchtkammer befestigt ist) ruhen.

An den Befestigungsrahmen 10a und 10b sind die als Axialstabilisierungsmagnete wirkenden Permanentmagnete 16a und 16b, die Drehfeldstatoren 17a und 17b der rotatorischen Antriebe sowie die Elemente der jeweils zwei Radialstabilisierungseinrichtungen befestigt. Diese Elemente sind je Radialstabilisierungseinrichtung vier Ringspulen 18a, 18aa, 18b, 18bb - von denen in Fig. 1 nur die beiden in der Zeichnungsebene liegenden dargestellt sind - mit ferromagnetischen Kern 19a, 19aa, 19b, 19bb, die mit den Regelgeräten 20a, 20aa, 20b, 20bb und Feldplatten 21a, 21aa, 21b, 21bb in elektrischer Verbindung stehen.

Die Ringspulen 18 entsprechen im übrigen den in der DE-OS 24 20 814 gemachten Angaben.

Bei der Herstellung des Kristalls 1 wird dieser aus der im Tiegel 2 befindlichen Schmelze, die sich auf konstanter Temperatur befindet, gezogen. Hierzu wird der Befestigungsrahmen 10a und mit diesem die Permanentmagnete 16a, an dem der magnetisierbare Kern 14a hängt, mittels der Spindeln 13a in axialer Richtung verschoben.

Kristall und Tiegel drehen - wie durch Pfeile angezeigt ist - gegenläufig.

Die Einrichtung zur Ermittlung des Reibungsmomentes zwischen Kristall und Schmelze und zur Regelung des Kristalldurchmessers besteht aus den Momentmeßzellen 12a, der Meßwertverarbeitung MV1, dem Sollwertgeber S und dem Regler R, der mit dem Motorgenerator MG des Spindelmotors SM in Verbindung steht.

Da die Momentmeßzellen 12a (beispielsweise drei) zwischen Befestigungsrahmen 10a und Platten 11a angeordnet sind, messen sie einander überlagerte Reigungsmomente, nämlich das zwischen Kristall und Schmelze und das Gasreibungsmoment zwischen dem im Zuchtraum befindlichen Gas und den sich drehenden Teilen. (Die beispielsweise durch Hystereseverluste bzw. Wirbelströme verursachte Lagerreibung wird, da Antriebsmotor und Magnetlager starr miteinander gekoppelt sind, im Befestigungsrahmen 10a kompensiert und daher bei dieser Messung nicht erfaßt).

Zur Ermittlung des gewünschten Reibungsmomentes zwischen Kristall und Schmelze wird das Gasreibungsmoment, das vorab separat ermittelt werden kann, als Korrekturgröße berücksichtigt. Das ermittelte Reibungsmoment ist ein Maß für den Kristalldurchmesser.

Das Singal der Momentmeßzellen wird in der Meßwertverarbeitung MV1 aufbereitet und in den Regler R eingespeist. Dieser gibt - bei Abweichung des Meßwertes vom Sollwert, der dem gewünschten Kristalldurchmesser entspricht - ein entsprechendes Signal an den Motorgenerator MG des Spindelmotors SM, was zu einer Korrektur des Linearvorschubs und damit zu einer Regelung des Kristalldurchmessers führt.

Fig. 1a sind die vier Ringspulen 18a sowie die zugehörigen Regler 20a zu entnehmen.

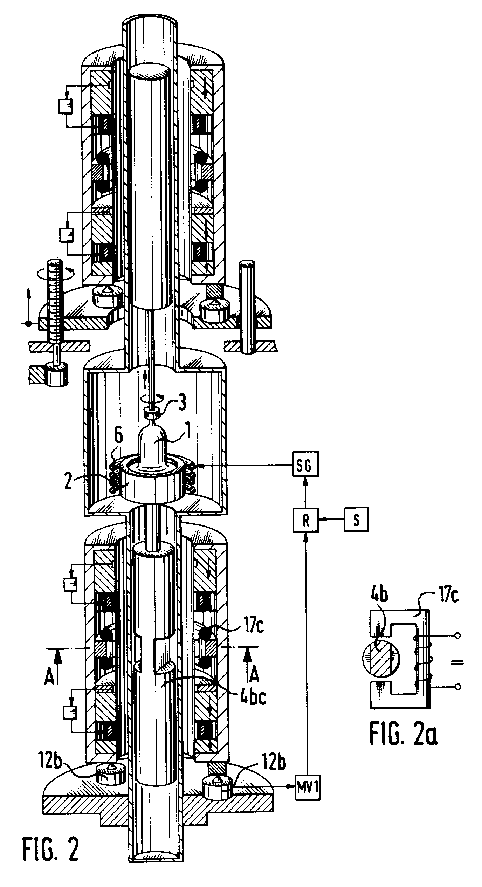

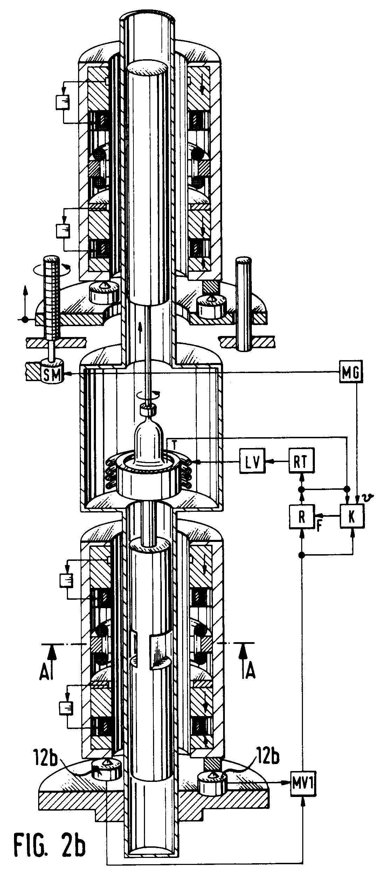

Bei der in Fig. 2 dargestellten Ausführungsform der Vorrichtung wird - anders als bei der in Fig. 1 dargestellten Vorrichtung - im Betriebszustand nur der Kristall gedreht, während der Tiegel mittels einer Magnetkupplung festgehalten wird. Hierzu ist der magnetisierbare Kern 4bc im Bereich der Außenelemente der Magnetkupplung 17c in besonderer Weise ausgeformt, um eine Fixierung des Kerns und damit des daran befestigten Tiegels zu ermöglichen.

Die Regelung des Durchmessers erfolgt bei der in Fig. 2 bzw. 2a dargestellten Vorrichtung ebenfalls nach der Verfahrensvariante b, jedoch über den feststehenden Tiegel, wobei das Reibungsmoment über die Magnetkupplung auf die Momentmeßzellen 12b - die Momentmeßzellen 12a bleiben ungenutzt - übertragen wird. In vereinfachter Darstellung besteht die Meß- und Regeleinrichtung aus der Meßwertverarbeitung MV1, dem Regler R, dem Sollwertgeber S und dem Hochfrequenzgenerator SG, einem regelbaren Netzgerät, das mit der Hochfrequenzspule 6 in Verbindung steht. Die von den Drehmomentmeßstellen 12b kommenden Signale werden in der Meßwertverarbeitung MV1 aufbereitet, in den Regler eingespeist, der diese Signale mit dem vom Sollwertgeber erhaltenen Sollwert vergleicht und je nach Abweichung vom Sollwert ein Signal an den Leistungsverstärker zur Einstellung der Heizungsleistung weitergibt.

Bei der in Fig. 2 beschriebenen Reibungsmomentmessung wird das Reibungsmoment zwischen Kristall und Schmelze, ohne daß es von anderen Reibungsmomenten überlagert wäre, direkt gemessen.

Da der Kristallzuchtprozess bei konstanter Temperatur der Schmelze durchzuführen ist, wird man zweckmäßigerweise den zu Fig. 2 beschriebenen Durchmesserregelkreis mit einem Temperaturregelkreis kombinieren, über den - wie aus Fig. 2b hervorgeht - die Temperatur der Schmelze gemessen und geregelt wird: ein innerer Regelkreis regelt die Schmelztemperatur. Das Ausgangssignal des Temperaturfühlers T wird als Stellgröße in den Temperaturregler RT eingegeben, dessen Ausgangssignal im Leistungsverstärker LV verstärkt in die Heizerwicklung eingespeist wird. Der Durchmesserregelkreis stellt den äußeren Regelkreis dar. Hier dient als Stellgröße das Drehmomentsignal der Momentmeßzelle bzw. der Momentmeßzellen 12b, das über den Meßwertumformer MV1 dem Durchmesserregler R zugeführt wird. Dessen Ausgangssignal wird dem Temperatursignal überlagert und bewirkt die gewünschte Modulation der Schmelzentemperatur.

Die Stellgrößen und weitere, für den Zuchtprozeß relevante Systemparameter, wie z.B. die Ziehgeschwindigkeit v können in einem Komputer K gespeist bzw. on-line verarbeitet werden zu einer Führungsgröße F (zu einem quasi zeitlich sich ändernden Sollwert) für den Durchmesserregelkreis.

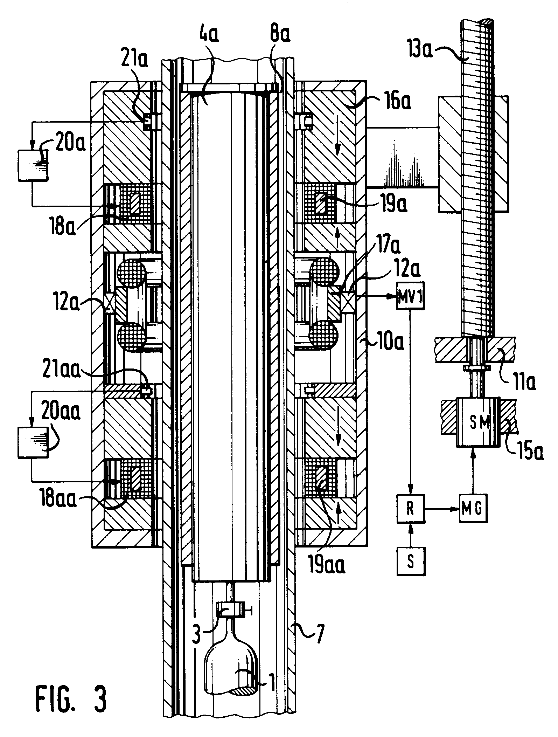

In den weiteren Fig. 3 - 6 ist jeweils nur der zur Erläuterung der verschiedenen Betriebsweisen der Meß- und Regeleinrichtung erforderliche Teil der Vorrichtung dargestellt.

Auch bei der in Fig. 3 wiedergegebenen Meß- und Regeleinrichtung wird nach der Verfahrensvariante b vorgegangen. Die Momentmeßzellen 12a sind in diesem Falle jedoch am Stator des Antriebsmotors angeordnet, so daß bei der Momentmessung die einander überlagerten Reibungsmomente zwischen Kristall und Schmelze, die Gasreibung und die Lagerreibung (beispielsweise durch Hystereseverluste im Rotor verursacht) erfaßt werden. Die Momente der Gasreibung und des Lagers, die vorab ermittelt werden können, müssen daher berücksichtigt werden.

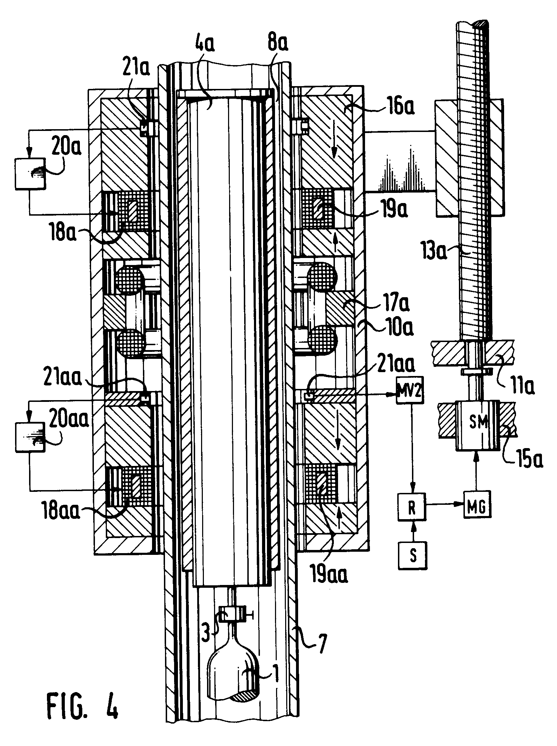

Bei der in Fig. 4 dargestellten Meß- und Regeleinrichtung wird nach der verfahrensvariante c) vorgegangen. Dazu wird das Unwuchtsignal der Sensoren 21aa einer Radialstabilisierungseinrichtung der Meßwertverarbeitung MV2, die mit einer Quarzuhr ausgestattet ist, zugeführt, von dieser in den Regler eingespeist, der sich wiederum am Sollwert orientert und ein entsprechendes Signal dem Motorgenerator MG zuleitet. Bei dieser Verfahrensweise werden die einander überlagerten Momente der Reibung zwischen Kristall und Schmelze, der Lager und der Gasreibung gemessen, so daß der Meßwert - wie oben erwähnt - zu korrigieren ist.

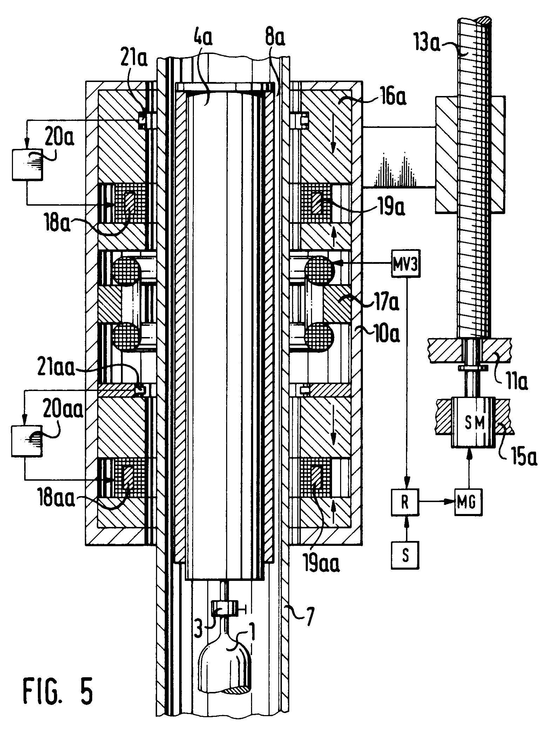

Bei der in Fig. 5 dargestellten Meß- und Regeleinrichtung wird nach der Verfahrensvariante a) vorgegangen. Der Antriebsmotor ist ein Synchronmotor, der mit konstanter Drehzahl läuft. Die elektrischen Antriebswerte werden der Meßwertverarbeitung MV3 und deren Ausgangssignale dem Regler R zugeleitet. Auch in diesem Falle erfolgt die Durchmesserregelung über den durch die Spindel bewirkten Linearvorschub. Bei Verfahrensvariante a) werden zunächst die einander überlagerten Momente der Reibung zwischen Kristall und Schmelze sowie der Lager und der Gasreibung erfaßt, so daß auch hier eine entsprechende Korrektur erforderlich ist.

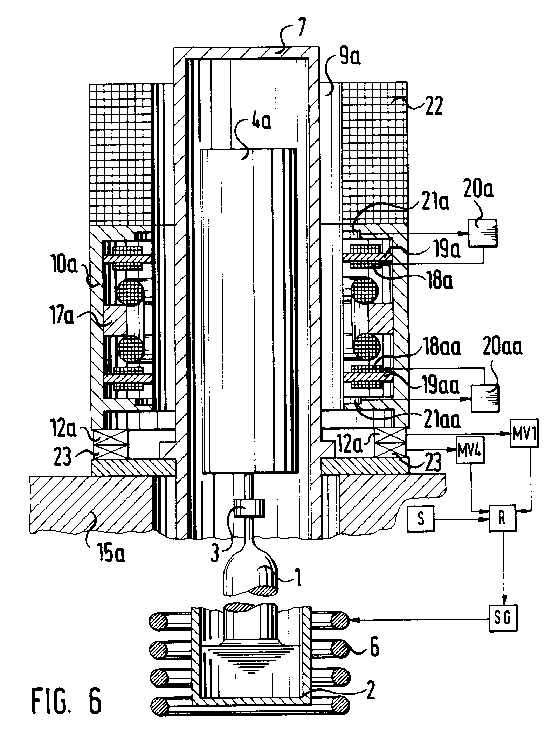

Bei der in Fig. 6 dargestellten Vorrichtung umschließt der ringförmig ausgebildete Linearmotor 22 den magnetisierbaren Kern 4a in Arbeitsstellung an dessen oberem Ende. Er ist zusammen mit den beiden Radialstabilisierungseinrichtungen und dem Drehfeldstator 17a mechanisch fest mit dem Befestigungsrahmen 10a verbunden, der über die Momentmeßzellen 12a und 23 auf der festen Unterlage 15a ruht.

Der Linearmotor 22 dient der axialen Fixierung des magnetisierbaren Kerns 4a und zugleich zu dessen axialer Verschiebung, so daß die axiale Verschiebung allein über magnetische Kräfte erfolgt und mechanische Mittel, wie Spindel u.dgl., entfallen. Der Linearmotor kann aus einem einfachen Tauchspulensystem bestehen, wobei die stabile axiale Höhenlage des magnetisierbaren Kerns eine Funktion des Spulenstromes ist. Die Länge des magnetisierbaren Kerns ist um die Hublänge über die axialen Statorabmessungen hinaus verlängert, so daß alle Arbeitsfunktionen über den gesamten Hubbereich gewährleistet sind.

Der Durchmesserregelkreis, der nach der aus der DE-PS 34 32 467 angegebenen Verfahrensweise arbeitet, besteht aus Kraftmeßeinrichtung 23, Meßwertumformer MV4, in dem das Gewichtssignal nach der Zeit differenziert wird, Sollwertgeber S, Regler R und Leistungsverstärker bzw. Hochfrequenzgenerator SG. In diesem Regelkreis wird das Signal der Momentmeßzellen 12a über den Meßwertumformer MV1 als Korrekturgröße eingespeist.

**Patentansprüche**

1. Verfahren zu Ermittlung einer Bestimmungsgröße für den Übergangsbereich zwischen Schmelze und Kristall bei einer Vorrichtung zum tiegellosen Zonenschmelzen oder zum Ziehen des Kristalls aus einem Tiegel, die einen elektrischen Antrieb zur Rotation des Kristalls und/oder des Tiegels aufweist,
   **dadurch gekennzeichnet,**
   daß eine Vorrichtung mit einer Stab- und/oder Tiegelhalterung verwendet wird, die Magneten (16a, 22) (Axialstabilisierungsmagnet) zur Aufhängung der einen magnetisierbaren Kern (4a, 4b) aufweisenden Halterung mit einer Einrichtung zur axialen Verschiebung und einer Radialstabilisierungseinrichtung für den magnetisierbaren Kern aufweist, die aus den magnetisierbaren Kern berührungslos umschließenden Elektromagneten (18a, 18aa, 18b, 18bb), einem elektronischen Regelgerät (20a, 20aa, 20b, 20bb) und Positionssensoren (21a, 21aa, 21b, 21bb) besteht, wobei die Elektromagnete vom elektronischen Regelgerät mit Signalen beaufschlagt werden, die von diesem als Funktion der Signale der Positionssensoren, welche auf die Abweichungen des magnetisierbaren Kerns und seiner Sollage ansprechen, erzeugt werden, wobei der elektrische Antrieb (17a, 17b) über Magnetfelder am magnetisierbaren Kern (4a, 4b) angreift, und daß
   a) das Reibungsmoment mittels elektrischer Daten des Antriebsmotors (17a) unter Berücksichtigung von Kennwerten des Antriebsmotors ermittelt wird oder
   b) das über Magnetfelder nach außen übertragene Reibungsmoment mittels Momentmeßzellen (12a, 12b) gemessen wird oder
   c) das Reibungsmoment aus der relativen Drehzahlabnahme der Stab- und/oder Tiegelhalterung je Zeiteinheit nach Abschalten des Antriebsmotors (17a) unter Berücksichtigung des aktuellen Trägheitsmoments der rotierenden Teile (1, 3, 4a und/oder 2, 4b) ermittelt wird.

2. Verfahren nach Anspruch 1,
   **dadurch gekennzeichnet,**
   daß die Verfahrensalternativen a) und b) bei konstanter Drehzahl der Stab- und Tiegelhalterung durchgeführt werden.

3. Verfahren nach Anspruch 1 oder 2,
   **dadurch gekennzeichnet,**
   daß das Reibungsmoment der Ermittlung des Kristalldurchmessers an der Phasengrenzfläche zwischen Schmelze und Kristall (1) dient, wobei das Reibungsmoment ein direktes Maß für den Kristalldurchmesser ist.

4. Verfahren nach Anspruch 3,
   **dadurch gekennzeichnet,**
   daß das Reibungsmoment als direktes Maß für den Kristalldurchmesser an der Phasengrenzfläche zwischen Schmelze und Kristall (1) in einem Regelkreis zur Regelung des Kristalldurchmessers eingesetzt wird.

5. Verfahren nach Anspruch 1,
   **dadurch gekennzeichnet,**
   daß das Reibungsmoment als Korrekturgröße bei der Regelung des Kristalldurchmessers über die Kristallgewichtsänderung mittels einer geeignet angeordneten Kraftmeßeinrichtung (23) eingesetzt wird.

6. Vorrichtung zum tiegellosen Zonenschmelzen oder zum Ziehen des Kristalls aus einem Tiegel zur Durchführung des Verfahrens nach einem der Ansprüche 1 bis 4 mit einer Stab- und/oder Tiegelhalterung, die Magneten zur Aufhängung der einen magnetisierbaren Kern aufweisenden Halterung mit einer Einrichtung zur azialen Verschiebung und eine Radialstabilisierungseinrichtung für den magnetisierbaren Kern aufweist, die aus den magnetisierbaren Kern berührungslos umschließenden Elektromagneten, einem elektronischen Regelgerät und Positionssensoren besteht, wobei die Elektromagnete vom elektronischen Regelgerät mit Signalen beaufschlagt werden, die von diesem als Funktion der Signale der Positionssensoren, welche auf die Abweichungen des magnetisierbaren Kerns von seiner Sollage ansprechen, erzeugt werden, und die einen elektrischen Antrieb zur Rotation der Halterung aufweist, der über Magnetfelder reibungsfrei am magnetisierbaren Kern angreift,
**dadurch gekennzeichnet,**
daß

- zur Durchführung der Verfahrensvariante a) eine Einrichtung (MV3) vorgesehen ist, die ein dem Reibungsmoment entsprechendes Ausgangssignal aus Meßdaten der aktuellen Antriebswerte des rotatorischen Antriebs (17a, 17b) unter Berücksichtigung von Kennwerten des Antriebsmotors erzeugt;
- zur Durchführung der Verfahrensvariante b) eine Drehmomentmeßeinrichtung mit Momentmeßzellen (12a, 12b) zur Messung des über Magnetfelder nach außen übertragenen Reibungsmomentes vorgesehen ist;
- zur Durchführung der Verfahrensvariante c) eine Einrichtung (21aa, MV2) vorgesehen ist, die ein dem Reibungsmoment entsprechendes Ausgangssignal aus der relativen Drehzahlabnahme der Halterung je Zeiteinheit nach Abschalten des Antriebsmotors (17a) unter Berücksichtigung des aktuellen Trägheitsmoments der rotierenden Teile (1, 3, 4a und/oder 2, 4b) erzeugt.

7. Vorrichtung nach Anspruch 6,
**dadurch gekennzeichnet,**
daß eine Magnetkupplung (4bc, 17c) zur Fixierung von Tiegel (2) oder Kristall (1) vorgesehen ist, die am magnetisierbaren Kern (4bc) angreift, und daß die Einrichtung (12b) zur Ermittlung des Reibungsmomentes mit Außenelementen (17c) der Magnetkupplung in Verbindung steht.

8. Vorrichtung nach Anspruch 6 oder 7 zur Durchführung der Verfahrensweise gemäß Anspruch 4,
**dadurch gekennzeichnet,**
daß eine Steuer- und Regeleinrichtung (S, R, MG; S, R, SG) zur Regelung des Kristalldurchmessers vorgesehen ist, in die der ermittelte Reibungsmoment-Meßwert als Maß für den Kristalldurchmesser eingespeist wird.

9. Vorrichtung nach Anspruch 6 oder 7 zur Durchführung der Verfahrensweise gemäß Anspruch 5,
**gekennzeichnet dadurch,**
die Kombination einer Regeleinrichtung (MV4, R, S, SG) zur Regelung des Kristalldurchmessers mittels einer geeignet angeordneten Kraftmeßeinrichtung mit einer Einrichtung (12a, MV1) zur Ermittlung des Reibungsmomentes, wobei der Reibungsmoment-Wert als Korrekturgröße eingesetzt wird.

**Claims**

1. Method of ascertaining a determining quantity for the transition region between melt and crystal in a device for crucibleless zone melting or for drawing the crystal from a crucible, which device has an electric drive for rotation of the crystal and/or of the crucible, characterised in that there is used a device with a bar and/or crucible support which has magnets (16a, 22) (axial stabilisation magnet) for the suspension of the support, comprising a magnetisable core (4a, 4b), having a means for axial displacement and a radial stabilisation device for the magnetisable core, consisting of electromagnets (18a, 18aa, 18b, 18bb) surrounding the magnetisable core without physical contact, an electronic control apparatus (20a, 20aa, 20b, 20bb) and position sensors (21a, 21aa, 21b, 21bb), the electromagnets being supplied by the electronic control apparatus with signals which are produced by the latter as a function of the signals of the position sensors, which respond to the deviations of the magnetisable core and its desired position, the electric drive (17a, 18b) acting by way of magnetic fields on the magnetisable core (4a, 4b), and that
   a) the friction moment is ascertained by means of electrical data of the drive motor (17a) whilst taking characteristic values of the drive motor into account, or
   b) the friction moment transmitted to the outside by means of magnetic fields is measured by means of moment-measuring cells (12a, 12b), or
c) the friction moment is ascertained from the relative rotational speed decrease of the bar and/or crucible support per unit of time after the switching-off of the drive motor (17a) taking into account the actual moment of inertia of the rotating parts (1, 3, 4a and/or 2, 4b).

2. Method according to claim 1, characterised in that the method alternatives a) and b) are carried out with a constant rotational speed of the bar and crucible support.

3. Method according to claim 1 or 2, characterised in that the friction moment is used for ascertaining the crystal diameter at the phase boundary surface between melt and crystal (1), and the friction moment is a direct measure for the crystal diameter.

4. Method according to claim 3, characterised in that the friction moment is used as a direct measure for the crystal diameter at the phase boundary surface between melt and crystal (1) in a control circuit for controlling the crystal diameter.

5. Method according to claim 1, characterised in that the friction moment is used as a correction quantity in the control of the crystal diameter through the agency of the crystal weight change by means of a suitably arranged force-measuring device (23),

6. Apparatus for crucibleless zone melting or drawing the crystal from a crucible, for carrying out the method according to one of claims 1 to 4, with a bar and/or crucible support, which has magnets for the suspension of the support, comprising a magnetisable core, with a means for axial displacement and a radial stabilisation device for the magnetisable core, which consists of electromagnets surrounding the magnetisable core without physical contact, of an electronic control apparatus and position sensors, the electromagnets being supplied by the electronic control apparatus with signals which are produced by the latter as a function of the signals of the position sensors which respond to deviations of the magnetisable core from its desired position, and which has an electric drive for rotation of the support which drive acts by means of magnetic fields in friction-free manner on the magnetisable core, characterised in that

- for carrying out the method variant a) there is provided a device (MV3) which produces an output signal, corresponding to the friction moment, from measurement data of the actual drive values of the rotatory drive (17a, 17b), taking characteristic values of the drive motor into account;
- for carrying out method variant b) there is provided a torque-measuring device with moment-measuring cells (12a, 12b) for measuring the friction moment transmitted to the outside via magnetic fields;
- for carrying out method variant c) a device (21aa, MV2) is provided which produces an output signal, corresponding to the friction moment, from the relative rotational speed decrease of the support per unit of time after the switching-off of the drive motor (17a) whilst taking into account the actual inertia moment of the rotating parts (1, 3, 4a and/ or 2, 4b).

7. Apparatus according to claim 6, characterised in that an electromagnetic clutch (4bc, 17c) for the fixing of crucible (2) or crystal (1) is provided which acts on the magnetisable core (4bc), and that the device (12b) for ascertaining the friction moment is connected to external elements (17c) of the electromagnetic clutch.

8. Apparatus according to claim 6 or 7 for carrying out the method according to claim 4, characterised in that a regulating and control device (S, R, MG; S, R, SG) for controlling the crystal diameter is provided into which the ascertained friction moment measurement value is fed as a measure for the crystal diameter.

9. Apparatus according to claim 6 or 7 for carrying out the method according to claim 5, characterised by the combination of a control device (MV4, R, S, SG) for control of the crystal diameter by means of a suitably arranged force-measuring device with a device (12a, MV1) for ascertaining the friction moment, the friction moment value being used as a correction quantity.

**Revendications**

1. Procédé pour déterminer un paramètre pour la zone de transition entre une masse fondue et un cristal dans un dispositif pour réaliser la fusion de zone sans creuset ou pour le tirage du cristal à partir d'un creuset, et qui comporte un dispositif d'entraînement électrique pour entraîner en rotation le cristal et/ou le creuset, caractérisé par le fait qu'on utilise un dispositif comportant un dispositif de support pour la tige et/ou le creuset, qui comporte des aimants (16a,22) (aimant de stabilisation axiale) pour suspendre le support, qui comporte un noyau aimantable (4a,4b) avec un dispositif servant à réaliser le déplacement axial et un dispositif de stabilisation radiale pour le noyau aimantable, qui est constitué par des électroaimants (18a, 18aa, 18b, 18bb), qui entourent sans le toucher le noyau aimantable, par un appareil de régulation électronique (20a, 20aa, 20b, 20bb) et des capteurs de position (21a, 21aa, 21b, 21bb), les électroaimants de l'appareil de régulation électronique étant chargés par des signaux qui sont produits par cet appareil en fonction des signaux des capteurs de positionnement qui répondent aux écarts du noyau aimantable par rapport à sa position de consigne, le dispositif d'entraînement électrique (17a,17b) agissant par l'intermédiaire de champs magnétiques sur le noyau aimantable (4a,4b), et que

a) le moment de frottement est déterminé au moyen de données électriques du moteur d'entraînement (17a) compte tenu de valeurs caractéristiques du moteur d'entraînement, ou

b) le moment de frottement transmis à l'extérieur par l'intermédiaire de champs magnétiques est mesuré au moyen de cellules (12a,12b) de mesure du moment, ou

c) le moment de frottement est déterminé à partir de la réduction relative de la vitesse de rotation du support de la tige et/ou du creuset, par unité de temps, après arrêt du moteur d'entraînement (17a), compte tenu du moment d'inertie effectif des pièces (1,3,4a et/ou 2,4b) en rotation.

2. Procédé suivant la revendication 1, caractérisé par le fait que les variantes a) et b) du procédé sont mises en oeuvre dans le cas où le support de la tige et le support du creuset tournent avec une vitesse de rotation constante.

3. Procédé suivant la revendication 1 ou 2, caractérisé par le fait que le moment de frottement est utilisé pour déterminer le diamètre du cristal au niveau de l'interface entre les phases formées par la masse fondue et le cristal (1), le moment de frottement étant une mesure directe du diamètre du cristal.

4. Procédé suivant la revendication 3, caractérisé par le fait que le moment de frottement est utilisé comme mesure directe du diamètre du cristal au niveau de l'interface entre les phases de la masse fondue et du cristal (1) dans un circuit de régulation servant à régler le diamètre du cristal.

5. Procédé suivant la revendication 1, caractérisé par le fait que le moment de frottement est utilisé en tant que grandeur de correction lors de la régulation du diamètre du cristal par l'intermédiaire de la variation du poids du cristal, au moyen d'un dispositif dynamométrique (23) installé de façon appropriée.

6. Dispositif pour réaliser la fusion de zones sans creuset ou pour tirer le cristal à partir d'un creuset pour la mise en oeuvre du procédé suivant l'une des revendications 1 à 4, comportant un support pour la tige et/ou un support pour le creuset, qui comporte des aimants (aimants de stabilisation axiale) pour suspendre le support, qui comporte un noyau aimantable avec un dispositif servant à réaliser le déplacement axial et un dispositif de stabilisation radiale pour le noyau aimantable, qui est constitué par des électroaimants, qui entourent sans le toucher le noyau aimantable, par un appareil de régulation électronique et des capteurs de position, les électroaimants de l'appareil de régulation électronique étant chargés par des signaux qui sont produits par cet appareil en fonction des signaux des capteurs de positionnement qui répondent aux écarts du noyau aimantable par rapport à sa position de consigne, le dispositif d'entraînement électrique agissant par l'intermédiaire de champs magnétiques sur le noyau aimantable, caractérisé par le fait

- que pour la mise en oeuvre de la variante a) du procédé, il est prévu un dispositif (MV3), qui produit un signal de sortie correspondant au moment de frottement, à partir de données de mesure des valeurs réelles d'entraînement du dispositif d'entraînement en rotation (17a,17b), compte tenu de valeurs caractéristiques du moteur d'entraînement;

- pour la mise en oeuvre de la variante b) du procédé, il est prévu un dispositif de mesure du moment de rotation comportant des cellules (12a,12b) de mesure du moment servant à mesurer le moment de frottement transmis à l'extérieur par l'intermédiaire de champs magnétiques;

- pour la mise en oeuvre de la variante c) du procédé, il est prévu un dispositif (21aa,MV2), qui produit un signal de sortie correspondant au moment de frottement, à partir de la réduction relative de la vitesse de rotation du support par unité de temps après l'arrêt du moteur d'entraînement (17a), compte tenu du moment d'inertie effectif des pièces en rotation (1,3,4a et/ou 2,4b).

7. Dispositif suivant la revendication 6, caractérisé par le fait qu'il est prévu un accouplement magnétique (4bc, 17c) pour fixer le creuset (2) ou le cristal (1) et qui attaque le noyau aimantable (4bc), et que le dispositif (12b) servant à déterminer le moment de frottement est raccordé à des éléments extérieurs (17c) de l'accouplement magnétique.

8. Dispositif suivant la revendication 6 ou 7 pour la mise en oeuvre du mode opératoire suivant la revendication 4, caractérisé par le fait qu'il est prévu un dispositif de commande et de régulation (S,R,MG; S,R,SG) servant à régler le diamètre du cristal et dans lequel la valeur de mesure déterminée du moment de frottement est introduite en tant que mesure du diamètre du cristal.

9. Dispositif suivant la revendication 6 ou 7 pour la mise en oeuvre du mode opératoire suivant la revendication 5, caractérisé par la combinaison d'un dispositif de régulation (MV4,R,S,SG) servant à régler le diamètre du cristal au moyen d'un dispositif dynamométrique disposé de façon appropriée et comportant un dispositif (12a,MV1) servant à déterminer le moment de frottement, la valeur du moment de frottement étant utilisée en tant que grandeur de correction.

FIG. 1

FIG. 1a

FIG. 2

FIG. 2a

FIG. 2b

FIG. 3

FIG. 4

FIG. 5

FIG. 6